Europäisches Patentamt

European Patent Office

Office européen des brevets

(19)

(11) Numéro de publication: **0 249 516**
**B1**

(12) **FASCICULE DE BREVET EUROPEEN**

(45) Date de publication du fascicule du brevet:
**25.07.90**

(51) Int. Cl.⁵: **C30B 23/06**

(21) Numéro de dépôt: **87401094.5**

(22) Date de dépôt: **14.05.87**

(54) Cellule pour épitaxie par jets moléculaires et procédé associé.

(30) Priorité: **15.05.86 FR 8606987**

(43) Date de publication de la demande:
**16.12.87 Bulletin 87/51**

(45) Mention de la délivrance du brevet:
**25.07.90 Bulletin 90/30**

(84) Etats contractants désignés:
**CH DE FR GB LI**

(56) Documents cités:
**EP-A- 0 122 088**
**US-A- 4 553 022**

(73) Titulaire: **COMMISSARIAT A L'ENERGIE ATOMIQUE,
31/33, rue de la Fédération, F-75015 Paris(FR)**

(72) Inventeur: **Demay, Yves, 34, rue Lénine, F-78210 Saint
Cyr(FR)**
Inventeur: **Gailliard, Jean Pierre, 74, rue des Eaux
Claires, F-38100 Grenoble(FR)**
Inventeur: **Million, Alain, 28 Boulevard Joseph Vallier,
F-38000 Grenoble(FR)**
Inventeur: **Piaguet, Jean, 6, rue Rabelais,
F-38320 Eybens(FR)**

(74)˙ Mandataire: **Mongrédien, André et al, c/o
BREVATOME 25, rue de Ponthieu, F-75008 Paris(FR)**

**Description**

L'épitaxie par jets moléculaires est une technique de formation de couches minces de nombreux matériaux sur un substrat en ultra-vide. Un jet moléculaire est obtenu en produisant une pression de vapeur du matériau en question dans une enceinte ou creuset isotherme, comportant une ouverture.

On connaît, selon l'art antérieur, les creusets longs dont les caractéristiques peuvent être bien déterminées. Une cellule de ce type est relativement satisfaisante lorsque sa température de fonctionnement est suffisamment élevée et lorsque le matériau source est à l'état liquide. Par contre, lorsqu'on utilise des matériaux fournissant le flux nécessaire par sublimation à basse température (Te, As, P, Zn, Cd, S, etc.) ces cellules présentent les inconvénients suivants :

Tout d'abord, le matériau peut se condenser à la gueule de la cellule, étant donné que cette dernière est environnée de panneaux refroidis à l'azote liquide. Cette condensation peut aller jusqu'au bouchage de l'orifice de la cellule.

Les pertes thermiques de la cellule, qui proviennent essentiellement du rayonnement en milieu ultra-vide, sont très faibles en raison de la faible température de fonctionnement. Par la suite, si l'on souhaite abaisser la température de la cellule, une baisse ne se produira que lentement après que l'on a coupé les moyens de chauffage. Il en résulte donc des difficultés de régulation thermique.

D'autre part, ces cellules sont difficiles, voire impossibles à étuver. L'étuvage est une opération consistant à chauffer l'ensemble de l'appareillage à épitaxie (enceinte à ultra-vide et cellule) à une température suffisante pour les dégazer. Cette opération s'effectue généralement à une température de l'ordre de 200 à 250°C qui peut être suffisante pour vider la cellule chargée d'un corps volatil.

En outre, ces cellules ne permettent pas d'obtenir des flux stables à partir de corps solides à cause de l'instabilité propre d'émission d'un solide. Ceci est dû à ce que la température du matériau n'est pas homogène en température. Le matériau se déplace, se déforme et s'évapore par bouffées. A cela s'ajoute l'inconvénient d'avoir des projections de particules solides.

De plus, le flux n'est pas reproductible au cours du temps en raison de la diminution de la charge.

Par ailleurs, le diamètre des orifices de sortie utilisés pour de telles cellules est suffisamment grand pour permettre l'entrée de molécules provenant d'autres cellules qui ont été réfléchies par le four, par le substrat ou qui n'ont pas été piégées par les panneaux refroidis environnants. L'interaction de ces molécules avec la charge de la cellule peut modifier le taux d'évaporation à une température donnée soit en dopant la source, soit en formant à la surface de la charge un nouveau composé, ce qui fait varier la surface d'émission, et constitue une nouvelle cause d'instabilité.

Enfin, le dégazage inévitable de l'élément chauffant est une source non négligeable de pollution de l'enceinte à ultra-vide, des substrats à revêtir et par voie de conséquence, des produits déposés.

L'invention a précisément pour objet une cellule pour épitaxie par jets moléculaires qui remédie à ces inconvénients.

Conformément l'invention, une cellule pour épitaxie par jets moléculaires comportant une chambre de vaporisation destinée à contenir un matériau a vaporiser, ce matériau possédant, à sa température de fusion, une pression de vapeur supérieure à $10^{-2}$ Pa, ladite chambre de vaporisation étant munie d'une ouverture pour émettre des jets moléculaires dudit matériau, des moyens de chauffage pour maintenir la chambre de vaporisation isotherme, est caractérisée en ce que la chambre est munie d'une seule ouverture ou d'une pluralité d'ouvertures de section déterminée de manière à obtenir un flux d'intensité voulue, le matériau à vaporiser étant à l'état liquide à l'intérieur de la chambre de vaporisation.

De préférence, un manchon thermique solidaire de la chambre de vaporisation entoure la (les) ouverture(s) de section déterminée, ce manchon faisant saillie au-delà de l'ouverture (des ouvertures), et comportant des moyens de chauffage permettant d'obtenir au niveau de l'ouverture (des ouvertures) une température suffisante pour éviter la condensation du matériau vaporisé passant au travers de ces ouvertures.

On entend par épitaxie par jet moléculaire une épitaxie au sens strict, ou un dépôt sans relation épitaxiale avec le substrat.

La formule générale qui lie le flux sortant d'une cellule contenant un gaz à la pression P et émettant dans le vide, à la section S de l'ouverture à travers laquelle il se produit, en supposant que cette ouverture est percée en paroi mince, est approximativement la suivante :

(1) $J = (2\pi MkT)^{-1/2} PS$ (en négligeant les corrections de détente adiabatique) et avec :

$J$ = flux,
$M$ = masse moléculaire de l'espèce évaporée,
$k$ = constante de Boltzmann,
$T$ = température absolue dans la cellule supérieure à la température de fusion du matériau,
$P$ = pression dans la cellule reliée à la température T de celle-ci par une loi de la forme :

$$\mathrm{Log}\ P = \frac{A}{T} + B$$

A et B étant des constantes caractéristiques du matériau évaporé.

Si l'on veut obtenir un flux incident F sur un substrat situé à une distance L de l'ouverture, il faut que : $J = ML^2 F$ (approximation de la loi de Lambert), d'où :

$$S = \frac{(2\pi^3 \, MkT)^{1/2} \, L^2 \, F}{P}$$

Ainsi, l'ordre de grandeur de la section de passage de l'ouverture (la somme des sections des ouvertures) est déterminée par la formule :

$$S = \frac{(2\pi^3 \, MkT)^{1/2} \, L^2 \, F}{P}$$

En particulier, le diamètre de l'ouverture de sortie des ouvertures est ≤1mm.

De préférence, la cellule comporte une deuxième paroi formée par retournement à 180° de la paroi du manchon thermique, un espace étant laissé libre entre la paroi externe de la cellule et la paroi externe du manchon thermique d'une part, et la paroi interne de la deuxième paroi d'autre part, lesdits moyens de chauffage étant logés dans cet espace.

L'ensemble constituant la cellule (chambre de vaporisation, manchon et moyens de chauffage) est fixé sur une bride de fixation assurant le positionnement désiré de chaque élément.

Selon un mode de réalisation préférentiel, la chambre de vaporisation et le manchon sont constitués, en tout ou partie, par une double enveloppe.

Dans une première variante de ce mode de réalisation, seule la paroi interne de la double enveloppe est tenue par la bride de fixation. Cette disposition permet de diminuer les risques de pollution de l'enceinte à ultra-vide en faisant écran aux produits de dégazage de l'élément chauffant qui n'est pas en vue directe du substrat sur lequel on fait l'épitaxie.

Dans une seconde variante de ce mode de réalisation, seule la paroi externe de la double enveloppe est assujettie sur la bride de fixation. Cet arrangement délimite une enceinte dans laquelle l'élément chauffant est parfaitement isolé de l'enceinte à ultra-vide et peut être mis, de manière indépendante, à l'atmosphère ou sous atmosphère contrôlée, ou sous vide.

De préférence, les moyens de chauffage sont constitués par une résistance lamellaire, placé à l'intérieur de la double enveloppe, formant à ses deux extrémités une résistance plus importante que dans sa partie médiane.

Les avantages de l'invention sont les suivants.

Etant donné que le matériau est porté à l'état liquide dans la chambre de vaporisation, il est brassé par des courants de convection qui homogénéisent sa température de manière bien meilleure que la simple conduction dans un solide qui se sublime. En conséquence, en raison de cette bonne homogénéité de température, la stabilité du flux est bien meilleure.

L'intensité du flux est limitée, et donc contrôlée par la section de l'ouverture (des ouvertures) de la chambre de vaporisation, et par la pression qui règne à l'intérieur de la cellule. Elle est indépendante du niveau du liquide et reste donc constante pendant l'opération d'épitaxie alors que, au contraire, dans le cas d'un creuset long de l'art antérieur, l'intensité du flux dépend de la position du niveau de la surface d'évaporation du matériau solide ou liquide par rapport à l'orifice de sortie et, par conséquent varie sans cesse. De plus, la pression à l'intérieur de la chambre de vaporisation étant trés grande par rapport à celle de l'enceinte à ultra-vide (dans un rapport voisin de $10^4$), l'intensité du flux est donc indépendante de la pression dans ladite enceinte à ultra-vide.

Le manchon surchauffé qui entoure la (ou les) ouverture(s) de la chambre de vaporisation élimine les risques de bouchage de cet(s) orifice(s).

Par ailleurs, les projections de particules solides et la pollution en retour sont supprimées, étant donné que la section de l'ouverture de la chambre de vaporisation est 10000 fois plus petite que celle des cellules standard. Il a été aussi vérifié expérimentalement qu'une cellule conforme à l'invention possède une émission angulaire semblable à celles des cellules de Knudsen dans la zone utile.

Dans le cas où la cellule comporte une pluralité d'ouvertures, cela permet de diriger des jets dans différentes directions et de couvrir des substrats de surfaces importantes.

Enfin, la double enveloppe de la cellule fait écran aux produits de dégazage de l'élément chauffant qui n'est plus en vue directe du substrat sur lequel on fait l'épitaxie. Les produits de dégazage évacués vers l'arrière sont pompés ou piégés par les panneaux refroidis voisins, limitant ainsi la pollution ou/et le dopage de la couche que l'on dépose.

Dans une autre variante, la double enveloppe est solidaire de la bride de fixation maintenant la cellule sur l'enceinte à ultra-vide, l'élément chauffant est alors entièrement isolé de l'enceinte à ultra-vide et les risques de pollution sont évités. Cette bride peut être équipée d'une ouverture permettant de mettre l'élément chauffant sous vide ou sous atmosphère contrôlée.

La présente invention a aussi pour objet un procédé de formation d'un jet moléculaire d'un matériau pour l'application à l'épitaxie par jet, ledit matériau possédant, à sa température de fusion, une pression de vapeur supérieure à $10^{-2}$ Pa, caractérisé en ce que l'on porte le matériau à vaporiser à l'état liquide dans une chambre de vaporisation comportant au moins une ouverture de diamètre déterminé, entourée d'un manchon, la température de la chambre de vaporisation étant maintenue isotherme et celle du manchon suffisante pour éviter la condensation du matériau dans ce dernier et dans l'ouverture de la chambre de vaporisation.

De préférence, le procédé dans lequel on désire obtenir un flux incident F sur un substrat situé à une distance L de l'ouverture de sortie de la chambre de vaporisation, est caractérisé en ce que :
- on détermine le flux J sortant de la cellule par la formule $J = M\,L^2F$ ;
- on choisit une température absolue T de fonctionnement de la cellule supérieure à la température de fusion $T_F$ du matériau, et on porte la cellule ainsi que le manchon à cette température T ;
- on détermine un ordre de grandeur de la section de passage S du flux au travers de la (des) ouverture(s) de sortie de la chambre de vaporisation par la formule :

$$S = \frac{(2\pi^3\,MkT)^{1/2}\,L^2\,F}{P}$$

S désignant la section totale de l'ouverture (des ouvertures).

D'autres caractéristiques et avantages de l'invention apparaîtront encore à la lecture de la description qui suit, d'un exemple de réalisation donné à titre illustratif et non limitatif, en référence aux figures annexées, sur lesquelles :

- la figure 1 est une vue d'ensemble d'une enceinte à ultra-vide renfermant un substrat et comportant une cellule pour épitaxie conforme à l'invention,
- la figure 2 est une vue à échelle agrandie de la cellule pour épitaxie représentée sur la figure 1,
- la figure 3 est une vue développée d'un moyen de chauffage préféré de la cellule représentée sur la figure 2,
- la figure 4 est une vue schématique de la cellule conforme à l'invention, équipée d'une double enveloppe solidaire de la bride de fixation.

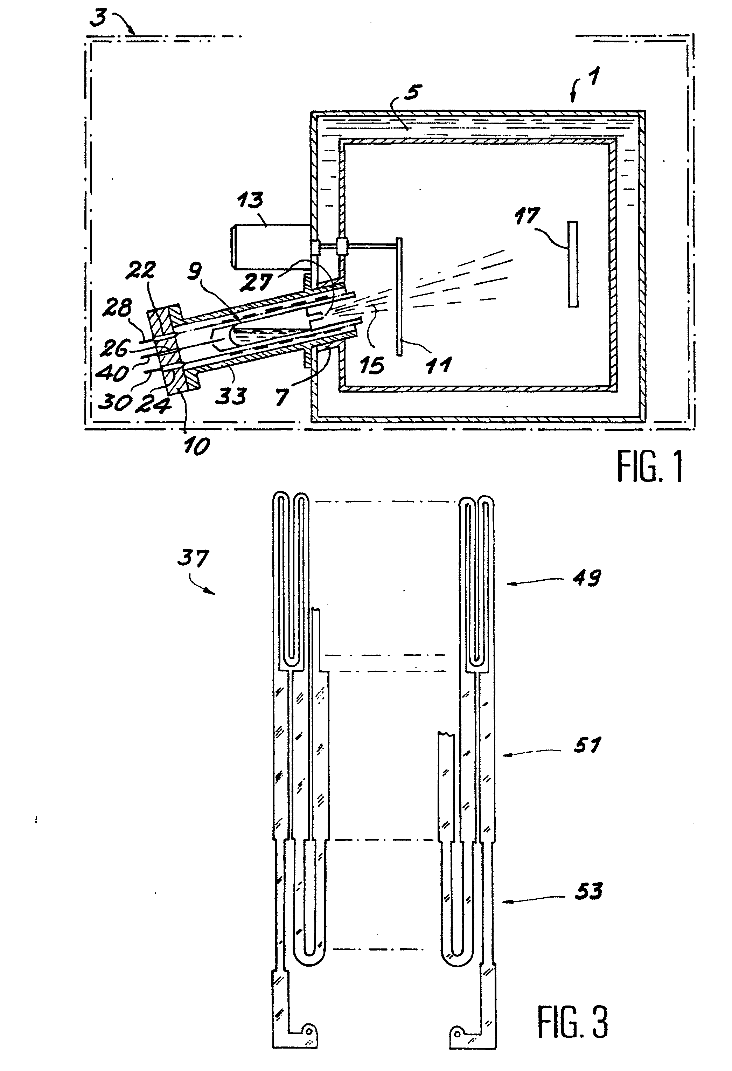

L'épitaxie par jets moléculaires est une méthode qui permet la préparation de films minces de nombreux matériaux. Dans les techniques de dépôt sous vide d'un produit par épitaxie par jets moléculaires sur un substrat à recouvrir, on emploie, comme représenté sur la figure 1, une enceinte ultra-vide 1 maintenue par exemple à une pression de l'ordre de $10^{-9}$ Torr et refroidie par un écran thermique constitué par une couche périphérique d'un gaz liquéfié à basse température, par exemple de l'azote. L'enceinte 1 comporte au moins une ouverture circulaire associée à une enveloppe 33 à l'intérieur de laquelle est introduite une cellule pour épitaxie par jets moléculaires désignée dans son ensemble par la référence générale 9.

Comme on le verra, cette cellule contient tout ou partie des produits à déposer maintenus à la température nécessaire, supérieure au point de fusion, par des moyens de chauffage qui entourent la cellule. Une bride de fixation 10 assure l'étanchéité de la cellule 9 et le maintien de tous les autres éléments de ladite cellule à l'intérieur de l'enveloppe 33. Elle est munie de passages étanches 22, 24, 26 pour les amenées de courant et le thermocouple. Un écran éclipsable 11 peut être mû en rotation par une commande externe 13 constituée par exemple par un moteur électrique. Lorsque l'écran 11 est éclipsé, le jet 15 produit par la cellule atteint le substrat 17 à revêtir situé dans l'enceinte 1.

Sur la figure 1, on a représenté une enceinte à ultra-vide avec une seule cellule à épitaxie par jets moléculaires ; toutefois, il est bien évident qu'une pluralité de cellules à épitaxie par jets moléculaires peut équiper ladite enceinte.

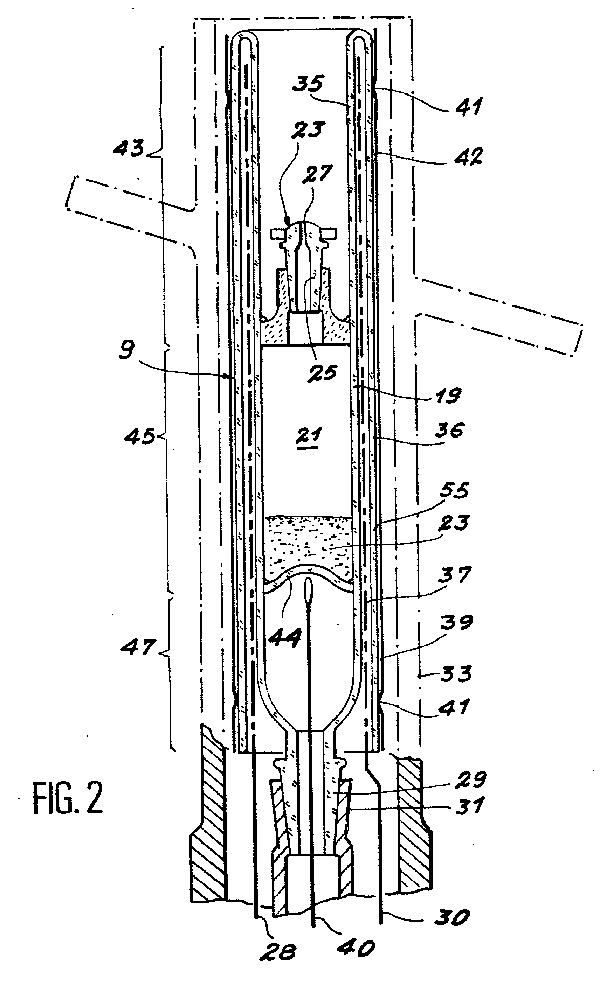

On a représenté sur la figure 2 une vue à échelle agrandie d'une cellule pour épitaxie moléculaire conforme à l'invention faisant partie de l'ensemble représenté sur la figure 1. Le corps de cellule 19 est constitué d'une enveloppe en quartz délimitant une chambre de vaporisation 21 qui contient le produit 23 dont on veut obtenir un jet moléculaire. La chambre 21 est fermée par un bouchon 25 percé d'une ouverture 27 de faible diamètre, calculée comme indiqué précédemment, de façon à maintenir liquide le matériau à vaporiser et à obtenir des jets moléculaires à flux contrôlé (valeur typique $10^{13}$ à $10^{15}$ molécules par $cm^2$ et par seconde sur le substrat).

A sa partie inférieure, le corps de cellule 19 est pourvu d'un cône 29 engagé dans un rodage correspondant prolongeant un support en quartz 31, lui-même solidaire d'une bride de fixation non représentée sur la figure 2, mais que l'on peut voir en 10 sur la figure 1. Cette bride de fixation comporte des passages étanches 22, 24, 26 pour les amenées de courant électrique 28, 30 et pour le thermocouple 40.

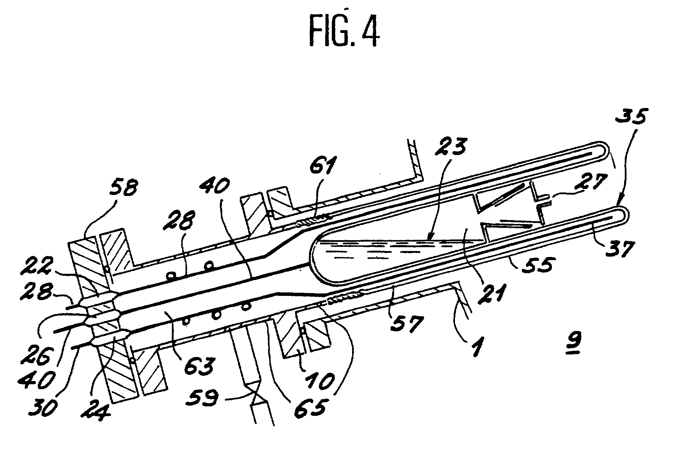

La paroi du corps de cellule se prolonge au-delà du bouchon 25 par un manchon 35 dont le diamètre intérieur est égal au diamètre intérieur de la chambre 21, bien que cette disposition ne soit pas obligatoire. Une double enveloppe 55 est réalisée, par exemple, par retournement à 180° de la paroi du manchon 35 à l'intérieur duquel sont logés des moyens de chauffage constitués de préférence par une résistance électrique 37 alimentée par deux conducteurs électriques 28, 30. Ceci permet à la résistance électrique 37 de s'autosupporter et évite que les produits de dégazage de la résistance ne soient en vue directe du substrat dans l'enceinte 1, substrat sur lequel on fait l'épitaxie, limitant ainsi la pollution ou/et le dopage de la couche que l'on dépose. Les produits de dégazage sont évacués par l'arrière de la cellule 19 pour être pompés ou piégés par les panneaux refroidis voisins. Un mode de réalisation préféré de la résistance électrique 37 sera décrit en référence à la figure 3.

Une feuille métallique 42, par exemple de tantale, enroulée autour du corps de cellule 19, constitue une isolation thermique qui limite les échanges de chaleur entre le corps de cellule porté à une température relativement élevée et la couche de gaz liquéfié qui entoure l'enceinte 1. On remarquera que la feuille de tantale 42 repose sur l'enveloppe 19 seulement par quelques tétons repoussés 41 situés à chacune de ses extrémités, de manière à délimiter un espace libre entre cette feuille et l'enveloppe afin d'améliorer l'isolation thermique de la cellule.

Le corps de la cellule 19 est ainsi composé de trois zones, respectivement une zone supérieure 43 dans laquelle est situé le manchon 35, une zone intermédiaire 45 correspondant à la chambre 21 contenant le produit à vaporiser, et une zone inférieure 47 constituée par la partie du corps de cellule qui va de la paroi inférieure 44 de la chambre 21 jusqu'au début du cône de fixation 29. Les moyens de chauffage 37 disposés entre la paroi externe du corps de cellule et le revers 36 apportent des quantités de chaleur différentes à chacune de ces trois zones, comme on le verra en référence à la figure 3.

On a représenté sur la figure 3 un mode de réalisation préféré des moyens de chauffage qui permettent d'échauffer le produit à déposer.

Ces moyens de chauffage 37 sont constitués par un conducteur électrique obtenu en découpant, par exemple une feuille mince de tantale par électro-érosion. Elle est composée de trois zones, à savoir une zone supérieure 49 selon la figure 3, une zone intermédiaire 51 et une zone inférieure 53. Ces trois zones correspondent aux zones 43, 45, 47 respectivement, de la cellule 19. On remarque que la section du conducteur est la plus faible dans la zone supérieure 49, puis dans la zone inférieure 53. Le conducteur présente une section relativement plus importante dans la zone intermédiaire 39. La résistance électrique du conducteur augmentant lorsque sa section diminue, le chauffage obtenu par effet Joule est plus important dans la zone supérieure 49 et dans la zone inférieure 53, de manière à éviter le refroidissement des extrémités du corps de cellule. La cellule est ainsi chauffée de manière isotherme. La partie supérieure 49 constitue la résistance de chauffage du manchon surchauffé qui permet d'éviter les problèmes de condensation en sortie de cellule. Les puissances de chauffe des parties 49, 51 et 53 peuvent être choisies dans de larges limites à la construction.

La figure 4 présente une autre variante de l'invention. Une double enveloppe 55 est obtenue par exemple par retournement à 180° de la paroi du manchon 35 prolongée par une partie 57 de manière à être rendue solidaire de la bride de fixation 10 par tout moyen assurant une étanchéité à l'ultra-vide. Sur la figure 4, la référence 61 représente une soudure quartz-métal assujettissant le manchon 35, la double enveloppe 55 et la partie 57 qui sont ici en quartz à la bride de fixation 10 qui est ici métallique. L'élément chauffant 37 est ainsi isolé de l'enceinte à ultra-vide 1 qui est à l'abri de toute pollution provenant du dégazage de l'élément chauffant 37. La bride de fermeture 58 qui détermine avec la bride de fixation 10 une enceinte 63, porte les passages étanches 22, 24, 26 nécessaires aux amenées de courant électrique 28, 30 et au thermocouple 40. Au moins une vanne 59 permet de mettre de manière indépendante l'élément chauffant 37 sous vide ou sous atmosphère contrôlée. Les matériaux utilisés pour la réalisation de la cellule ainsi que la géométrie de cette dernière peuvent être quelconques.

On donne, ci-après, deux exemples de mise en oeuvre de la cellule selon l'invention.

## EXEMPLE I

Corps à déposer : tellure (évaporation sous forme de $Te_2$), M=255,2.

La température de fusion du tellure étant de 722,5 K, on choisit, par exemple, une température T de fonctionnement de la cellule de 773 K. A cette température T, la pression de $Te_2$ est d'environ P=0,8 Torr. Si le substrat est placé à une distance L=10cm de la cellule et si on désire utiliser un flux $F=10^{14}$ molécules par $cm^2$ et par seconde (valeur typique utilisée en épitaxie par jets moléculaires) :
$S=4,99 \times 10^{-4} cm^2 = 499 \times 10^4 \mu m^2$
Pour un trou cylindrique le diamètre doit être égal à 252$\mu$m.

## EXEMPLE II

Corps à déposer : cadmium (Cd), M=112,4, T=623 K, P=0,29 Torr, $F=10^{14}$ molécules par $cm^2$ et par seconde, L=10 cm :
$S=8,20 \times 10^{-4} cm^2 \quad S=820 \times 10^4 \mu m^2$
Pour un trou cylindrique le diamètre doit être égal à 323$\mu$m environ.

**Revendications**

1. Cellule pour épitaxie par jets moléculaires comportant une chambre de vaporisation (21) destinée à contenir un matériau (23) à vaporiser, ce matériau (23) possédant, à sa température de fusion, une pression de vapeur supérieure à $10^{-2}$ Pa, ladite chambre de vaporisation (21) étant munie d'une ouverture (27) pour émettre des jets moléculaires dudit matériau (23), des moyens de chauffage (37) pour maintenir la chambre de vaporisation (21) isotherme, caractérisée en ce que la chambre (21) est munie d'une seule ouverture (27) ou d'une pluralité d'ouvertures (27) de section déterminée, de manière à obtenir un flux d'intensité (J) voulue, le matériau à vaporiser (23) étant à l'état liquide à l'intérieur de la chambre de vaporisation (21) et en ce qu'un manchon thermique (35) solidaire de la chambre de vaporisation (21) entoure la (les) ouverture(s) (27) de section déterminée, ce manchon (35) faisant saillie au-delà de l'ouverture (des ouvertures) (27), et comportant des moyens de chauffage (37) permettant d'obtenir au niveau de l'ouverture (des ouvertures) (27) une température suffisante pour éviter la condensation du matériau vaporisé passant au travers de ces ouvertures.

2. Cellule selon la revendication 1, caractérisée en ce que l'ordre de grandeur de la section de passage (S) de l'ouverture (la somme des sections des ouvertures) (27) est déterminée par la formule :

$$S = \frac{(2\pi^3 MkT)^{1/2} L^2 F}{P}$$

dans laquelle M est la masse moléculaire du matériau (23), k est la constante de Boltzmann, T la température absolue, supérieure à la température de fusion du matériau, régnant à l'intérieur de la cellule, L la distance séparant la (les) ouverture(s) (27) du substrat, F le flux incident que l'on désire obtenir sur ce substrat, P la pression dans la cellule à la température absolue T.

3. Cellule selon la revendication 1 ou la revendication 2, caractérisée en ce que le diamètre de l'ouverture de sortie (des ouvertures) (27) est $\leq 1$ mm.

4. Cellule selon l'une quelconque des revendications 1 à 3, caractérisée en ce qu'elle comporte une deuxième paroi formée par retournement à 180° de la paroi du manchon thermique (35), un espace étant laissé libre entre la paroi externe de la cellule et la paroi externe du manchon thermique d'une part, et la paroi interne de la deuxième paroi (55) d'autre part, lesdits moyens de chauffage (37) étant logés dans cet espace.

5. Cellule selon la revendication 4, caractérisée en ce que la paroi (19) de la cellule est tenue par une bride de fixation (10).

6. Cellule selon la revendication 4, caractérisée en ce que la deuxième paroi (55) est reliée par une soudure (61) à une virole de fixation (65) fermée, cette virole (65) étant solidaire d'une bride (10) apte à être montée de manière étanche sur une enceinte à vide (1), ladite virole (65) déterminant avec le volume interne compris entre les parois externes de la chambre de vaporisation (21) et du manchon thermique (35) d'une part, et la paroi interne de la deuxième paroi (55) d'autre part, une enceinte étanche dans laquelle ledit élément chauffant (37) est entièrement contenu.

7. Cellule selon la revendication 6, caractérisée en ce que les moyens de chauffage sont constitués par une résistance lamellaire (37), placée à l'intérieur de l'enceinte étanche (63) formant à ses deux extrémités une résistance plus importante que dans sa partie médiane.

8. Cellule selon la revendication 7, caractérisée en ce que la résistance lamellaire (37) est constituée par une feuille métallique découpée, comportant une section supérieure (49) disposée autour du manchon thermique (35), une section intermédiaire (51) entourant la cellule (19) et une section inférieure (53), la section de la résistance étant relativement plus faible dans les sections inférieure (53) et supérieure (49) que dans la section intermédiaire (51).

9. Cellule selon l'une quelconque des revendications 1 à 7, caractérisée en ce que la cellule (19), le manchon thermique (35), la deuxième paroi (55) et une partie (57) prolongeant la paroi (55) sont en quartz.

10. Procédé de formation d'un jet d'un matériau pour l'application à l'épitaxie par jet moléculaire sur un substrat, ledit matériau possédant, à sa température de fusion, une pression de vapeur supérieure à $10^{-2}$ Pa, caractérisé en ce que l'on porte le matériau à vaporiser (23) à l'état liquide dans une chambre de vaporisation (21) comportant au moins une ouverture (27) de diamètre déterminé, entourée d'un manchon (35), la température de la chambre de vaporisation (21) étant maintenue isotherme et celle du manchon (35) suffisante pour éviter la condensation du matériau dans ce dernier et dans l'ouverture (27) de la chambre de vaporisation.

11. Procédé selon la revendication 10, dans lequel on désire obtenir un flux incident F sur un substrat situé à une distance L de l'ouverture de sortie (27) de la chambre de vaporisation, caractérisé en ce que:
- on détermine le flux J sortant de la cellule par la formule $J = M L^2 F$ ;
- on choisit une température absolue T de fonctionnement de la cellule supérieure à la température de fusion $T_F$ du matériau, et on porte la cellule ainsi que le manchon à cette température T ;
- on détermine un ordre de grandeur de la section de passage S du flux au travers de la (des) ouverture(s) de sortie (27) de la chambre de vaporisation (21) par la formule :

$$S = \frac{(2\pi^3 MkT)^{1/2} L^2 F}{P}$$

dans laquelle M est la masse moléculaire du matériau (23), k est la constante de Boltzmann, L la distance séparant la (les) ouverture(s) (27) du substrat, F le flux incident que l'on désire obtenir sur ce substrat, P la pression dans la cellule à la température absolue T.

12. Procédé selon la revendication 11, caractérisé en ce que l'écart entre la température d'équilibre de fonctionnement de la cellule et la température de fusion du matériau (23) est au moins égal à 20°C.

**Claims**

1. Cell for molecular beam epitaxy having a vaporization chamber (21) for containing a material (23) to be vaporized, said material (23) having at its melting point a vapour pressure exceeding 10⁻² Pa, said vaporization chamber (21) being provided with an opening (27) for the emission of the molecular beams of said material (23) and heating means (37) for keeping the vaporization chamber (21) isothermal, characterized in that the chamber (21) is provided with a single opening (27) or a plurality of openings (27) of given cross-section determined in such a way as to obtain a flow of desired intensity (J), the material (23) to be vaporized being in the liquid state within the vaporization chamber (21) and in that a thermal sleeve (35) integral with the vaporization chamber (21) surrounds the opening or openings (27) of given cross-section, said sleeve (35) projecting beyond the opening or openings (27) and having heating means (37) making it possible to obtain at the same a temperature adequate for preventing the condensation of the vaporized material passing through said openings (27).

2. Cell according to claim 1, characterized in that the order of magnitude of the passage cross-section (5) of the opening (27) (the sum of the cross-section of the openings) is determined by the formula:

$$S = \frac{(2\pi^3 MkT)^{1/2} L^2 F}{P}$$

in which M is the molecular mass of the material (23), k is the Boltzmann constant, T is the absolute temperature higher than the melting point of the material prevailing within the cell, L the distance separating the opening or openings (27) from the substrate, F the incident flow which it is wished to obtain on the substrate and P the pressure in the cell at the absolute temperature T.

3. Cell according to claim 1 or 2, characterized in that the diameter of the outlet port or ports (27) is ≤ 1 mm.

4. Cell according to any one of the claims 1 to 3, characterized in that it has a second wall formed by turning by 180° the wall of the thermal sleeve (35), a space being left free between the outer wall of the cell and the outer wall of the thermal sleeve on the one hand and the inner wall of the second wall (55) on the other, said heating means (37) being located in said space.

5. Cell according to claim 4, characterized in that the wall (19) of the cell is held by a fixing flange (10).

6. Cell according to claim 4, characterized in that the second wall (55) is connected by a weld (61) to a sealed fixing ferrule (65), the latter being integral with a flange (10) which can be sealingly mounted on a vacuum enclosure (1), said ferrule (65) defining with the internal volume between the outer walls of the vaporization chamber (21) and the thermal sleeve (35) on the one hand and the inner wall of the second wall (55) on the other, a tight enclosure in which the heating element (37) is entirely contained.

7. Cell according to claim 6, characterized in that the heating means are constituted by a lamellar resistor (37) placed within the tight enclosure (63) and forming at its two ends a higher resistance than in its central part.

8. Cell according to claim 7, characterized in that the lamellar resistor (37) is constituted by a cut metal sheet having an upper zone (49) around the thermal sleeve (35), an intermediate zone (51) around the cell (19) and a lower zone (53), the cross-section of the resistor being smaller in the lower (53) and upper (49) zones than in the intermediate zone (51).

9. Cell according to any one of the claims 1 to 7, characterized in that the cell (19), the thermal sleeve (35), the second wall (55) and a portion (57) extending the wall (55) are made from quartz.

10. Process for the formation of a beam of a material for molecular beam epitaxy application to a substrate, whereby said material has at its melting point a vapour pressure exceeding 10⁻² Pa, characterized in that the material (23) to be vaporized is brought into the liquid state in a vaporization chamber (21) having at least one opening (27) of given diameter and surrounded by a sleeve (35), the temperature of the vaporization chamber (21) being kept isothermal and that of the sleeve (35) adequate to prevent condensation of the material in the latter and in the opening (27) of the vaporization chamber.

11. Process according to claim 10 in which it is wished to obtain an incident flow F on a substrate located at a distance L from the outlet port (27) of the vaporization chamber, wherein the flow J leaving the cell is determined by the formula J = M $L^2$F, an absolute operating temperature T of the cell exceeding the melting point $T_F$ of the material is chosen and the cell and the sleeve are raised to said temperature T and an order of magnitude of the passage cross-section S of the flow through the outlet port or ports (27) of the vaporization chamber (21) is determined by the formula:

$$S = \frac{(2\pi^3 MkT)^{1/2} L^2 F}{P}$$

in which M is the molecular mass of the material (23), k is the Boltzmann constant, L the distance separating the port or ports (27) from the substrate, F the incident flow which it is desired to obtain on the substrate and P the pressure in the cell at the absolute temperature T.

12. Process according to claim 11, characterized in that the difference between the equilibrium temperature of operation of the cell and the melting point of the material (23) is at least equal to 20°C.

## Patentansprüche

1. Zelle für die Epitaxie durch Molekularstrahlen, die umfaßt eine Verdampfungskammer (21) für die Aufnahme des zu verdampfenden Materials (23), das bei seiner Schmelztemperatur einen Dampfdruck von über $10^{-2}$ Pa hat, wobei die Verdampfungskammer (21) ausgestattet ist mit einer Öffnung (27) zum Emittieren von Molekularstrahlen aus dem Material (23), und Heizeinrichtungen (37), um die Verdampfungskammer (21) in einem isothermen Zustand zu halten, dadurch gekennzeichnet, daß die Kammer (21) ausgestattet ist mit einer einzigen Öffnung (27) oder mit einer Vielzahl von Öffnungen (27) mit einem vorgegebenen Querschnitt, so daß ein Fluß mit einer gewollten Intensität (J) erhalten wird, wobei das zu verdampfende Material (23) in einem flüssigen Zustand im Innern der Verdampfungskammer (21) vorliegt, und daß ein mit der Verdampfungskammer (21) verbundener Heizmantel (35) die Öffnung(en) (27) mit festgelegtem Querschnitt umgibt, wobei dieser Mantel (35) über die Öffnung(en) (27) hinaus vorsteht und Heizeinrichtungen (37) aufweist, die in Höhe der Öffnung(en) (27) die Erzielung einer Temperatur erlauben, die ausreicht, um die Kondensation des verdampften Materials beim Passieren dieser Öffnungen zu vermeiden.

2. Zelle nach Anspruch 1, dadurch gekennzeichnet, daß die Größenordnung des Durchgangsquerschnittes (S) der Öffnung (die Summe der Querschnitte der Öffnungen) (27) durch die folgende Formel bestimmt wird:

$$S = \frac{(2\pi^3 MkT)^{1/2} L^2 F}{P}$$

worin M die molekulare Masse des Materials (23), k die Boltzmann-Konstante, T die absolute Temperatur oberhalb der Schmelztemperatur des Materials, die im Innern der Zelle vorliegt, L den Abstand, der die Öffnung(en) (27) von dem Substrat trennt, F den auftreffenden Fluß, den man auf dem Substrat zu erzielen wünscht, und P den Druck in der Zelle bei der absoluten Temperatur T bedeuten.

3. Zelle nach Anspruch 1 oder 2, dadurch gekennzeichnet, daß der Durchmesser der Austrittsöffnung(en) (27) ≤ 1 mm beträgt.

4. Zelle nach einem der Ansprüche 1 bis 3, dadurch gekennzeichnet, daß sie eine zweite Wand aufweist, die gebildet wird durch Umwendung der Wand des Heizmantels (35) um 180°, wobei zwischen der äußeren Wand der Zelle und der äußeren Wand des Heizmantels einerseits und der inneren Wand der zweiten Wand (55) andererseits ein Zwischenraum freigelassen wird, in dem die genannten Heizeinrichtungen (37) angeordnet sind.

5. Zelle nach Anspruch 4, dadurch gekennzeichnet, daß die Wand (19) der Zelle von einem Fixierbügel (10) festgehalten wird.

6. Zelle nach Anspruch 4, dadurch gekennzeichnet, daß die zweite Wand (55) durch eine Schweißstelle (61) mit einer geschlossenen Fixiermanschette (65) verbunden ist, wobei diese Manschette (65) mit einem Bügel (10) verbunden ist, der dicht auf einen Vakuumbehälter (1) montiert werden kann, wobei die Manschette (65) zusammen mit dem Innenvolumen zwischen den äußeren Wänden der Verdampfungskammer (21) und dem Heizmantel (35) einerseits und der Innenwand der zweiten Wand (55) andererseits einen dichten Behälter bildet, in dem das Heizelement (37) vollständig enthalten ist.

7. Zelle nach Anspruch 6, dadurch gekennzeichnet, daß die Heizeinrichtungen aus einem Lamellen-Widerstand (37) bestehen, der im Innern des dichten Behälters (63) angeordnet ist, der an seinen beiden Enden einen höheren Widerstand als in seinem Mittelabschnitt bildet.

8. Zelle nach Anspruch 7, dadurch gekennzeichnet, daß der Lamellen-Widerstand (37) aus einer zugeschnittenen Metallfolie besteht, die einen oberen Abschnitt (49), der um den Heizmantel (35) herum angeordnet ist, einen mittleren Abschnitt (51), der die Zelle (19) umgibt, und einen unteren Abschnitt (53) aufweist, wobei der Querschnitt des Widerstandes in dem unteren Abschnit (53) und in dem oberen Abschnit (49) relativ dünner ist als in dem mittleren Abschnitt (51).

9. Zelle nach einem der Ansprüche 1 bis 7, dadurch gekennzeichnet, daß die Zelle (19), der Heizmantel (35), die zweite Wand (55) und ein Abschnitt (57), der die Wand (55) verlängert, aus Quarz sind.

10. Verfahren zur Erzeugung eines Strahls aus einem Material für die Anwendung in der Epitaxie durch Auftreffenlassen eines Molekularstrahls auf ein Substrat, wobei das Material bei seiner Schmelztemperatur einen Dampfdruck von über $10^{-2}$ Pa aufweist, dadurch gekennzeichnet, daß man das zu verdampfende Material (23) in einer Verdampfungskammer (21), die mindestens eine Öffnung (27) mit einem festgelegten Durchmesser aufweist, die von einem Mantel (35) umgeben ist, in den flüssigen Zustand überführt, wobei die Temperatur der Verdampfungskammer (21) in einem isothermen Zustand gehalten wird und diejenige des Mantels (35) bei einem Wert gehalten wird, der ausreicht, um die Kondensation des Materials in letzterem und in der Öffnung (27) der Verdampfungskammer zu vermeiden.

11. Verfahren nach Anspruch 10, in dem man einen auf ein Substrat auftreffenden Fluß F zu erzielen wünscht, das in einem Abstand L von der Austrittöffnung (27) der Verdampfungskammer angeordnet ist, dadurch gekennzeichnet, daß man

– den die Zelle verlassenden Fluß J durch die Formel $J = M \times L^2 \times F$ bestimmt;

– eine absolute Arbeitstemperatur T der Zelle auswählt, die oberhalb der Schmelztemperatur $T_F$ des Materials liegt, und die Zelle sowie den Mantel auf diese Temperatur T bringt;

– eine Größenordnung des Durchgangsquerschnitts S des Flusses durch die Austrittsöffnung(en) der Verdampfungskammer (21) durch die Formel bestimmt:

$$ S = \frac{(2\pi^3 MkT)^{1/2} L^2 F}{P} $$

in der M die Molekularmasse des Materials (23), k die Boltzmann-Konstante, L den Abstand, der die Öffnung(en) (27) von dem Substrat trennt, F den auftreffenden Fluß, den man auf dem Substrat zu erzielen wünscht, und P den Druck in der Zelle bei der absoluten Temperatur T bedeuten.

12. Verfahren nach Anspruch 11, dadurch gekennzeichnet, daß der Abstand zwischen der Arbeitsgleichgewichtstemperatur der Zelle und der Schmelztemperatur des Materials (23) mindestens 20°C beträgt.

EP 0 249 516 B1

FIG. 1

FIG. 3

FIG. 2

# FIG. 4